# EUROPEAN PATENT APPLICATION

(11) **EP 3 605 171 A1**
(43) Date of publication of application: **05.02.2020**
(21) Application number: 17901832.0
(22) Date of filing: 03.11.2017
(51) Int. Cl.: G02B 6/12

(54) **ARRAY LASER RADAR LIGHT SPLITTING DEVICE AND LIGHT SPLITTING METHOD THEREOF**

(30) Priority: 24.03.2017 CN 201710184407
(71) Applicant: O-Net Communications (Shenzhen) Limited, Shenzhen, Guangdong 518000 (CN)
(72) Inventor: LU, Kaiyuan, Shenzhen, Guangdong 518000 (CN); HUA, Yimin, Shenzhen, Guangdong 518000 (CN)
(74) Representative: Li, Xiaolu
(86) International application number: PCT/CN2017/109281
(87) International publication number: WO 2018/171205

(57) **Abstract**

The present disclosure provides an array-type light source light-splitting device and a light splitting method thereof. The array-type light source light-splitting device includes a seed source inputting signal light, an optical fiber amplifier connected with the seed source, and a light splitter connected with the optical fiber amplifier. The light splitter includes N paths of optical fibers. N is a natural number. The light splitter splits the signal light of the seed source into N paths and outputs them. The light splitter splits the signal light of the seed source into multi-path signal light and outputs them, meanwhile the power is amplified by the optical fiber amplifier of each path to become the multi-path signal light and outputs them. A repetition rate of the 1550 nm laser is able to reach megahertz.

## Description

### TECHNICAL FIELD

The present disclosure relates to a field of optical transmission technology, and in particular to an array-type light source light-splitting device and light-splitting method thereof.

### BACKGROUND

A laser radar is a radar system that emits a laser beam to detect a position and velocity of a target. At present, most of the laser radar light sources use semiconductor lasers with a wavelength of 905 nm, however their frequencies are low and a human eye safety threshold is low. Further, the light source uses an asynchronous operation mode during scanning.

### SUMMARY

An object of the present disclosure is to provide an array-type light source light-splitting device and a light-splitting method thereof that uses a synchronous operation mode and outputs multi-channel signal light.

The present disclosure provides an array-type light source light-splitting device, including a seed source inputting signal light, an optical fiber amplifier connected with the seed source, and a light splitter connected with the optical fiber amplifier. The light splitter includes N paths of optical fibers. N is a natural number. The light splitter splits the signal light of the seed source into N paths and outputs them.

Furthermore, the N paths of optical fibers are arranged parallelly. The N paths of optical fibers includes a first path optical fiber, a second path optical fiber, a third path optical fiber..., and a Nth path optical fiber.

Furthermore, the seed source is a laser with a wavelength of 1550 nm.

Furthermore, the optical fiber amplifier includes rare-earth-doped elements internally.

The present disclosure further provides a light-splitting method of the array-type light source light-splitting device, including following steps:
emitting signal light to an optical fiber amplifier by a seed source;
obtaining the signal light of the seed source by the optical fiber amplifier, and the optical fiber amplifier amplifies the signal light of the seed source and increases a power of the signal light of the seed source;
outputting the signal light of the seed source to a light splitter by the optical fiber amplifier; and
splitting the signal light of the seed source into N paths and outputting by the light splitter.

The present disclosure further provides an array-type light source light-splitting device, including a seed source inputting signal light, a light splitter connected with the seed source, and N optical fiber splitters connected with the light splitter. N is a natural number. The N optical fiber splitters split the signal light of the seed source into N paths and outputs them.

Furthermore, the N optical fiber splitters are arranged parallelly. The N optical fiber splitters include a first optical fiber amplifier, a second optical fiber amplifier, a third optical fiber amplifier..., and a Nth optical fiber amplifier.

Furthermore, the seed source is a laser with a wavelength of 1550 nm.

Furthermore, the optical fiber amplifier includes rare-earth-doped elements internally.

The present disclosure further provides a light-splitting method of the array-type light source light-splitting device according to any claims 6 to 9, comprising following steps:
emitting signal light to a light splitter by a seed source;
obtaining the signal light of the seed source by the light splitter, and the light splitter splits the signal light of the seed source in to N paths;
entering the first optical fiber amplifier, the second optical fiber amplifier, the third optical fiber amplifier..., and the Nth optical fiber amplifier sequentially from the N paths of the signal light split by the light splitter; and
amplifying the signal light of the seed source and increasing a power of the signal light of the seed source by the first optical fiber amplifier, the second optical fiber amplifier, the third optical fiber amplifier..., and the Nth fiber optical amplifier, and output the signal light of the seed source respectively.

The light splitter splits the signal light of the seed source of the present disclosure into multi-path signal light and outputs them, meanwhile the power is amplified by the optical fiber amplifier of each path to become the multi-path signal light and outputs them. A repetition rate of the 1550 nm laser is able to reach megahertz. Moreover, the laser has a high-water absorption coefficient, and when the laser beam radiates to the human eyes, a damage threshold to the human eyes is high. Thus, the laser in the band is safety to the human eyes. The light source of the present disclosure adopts a synchronous working mode, and has broad application prospects in fields of automatic driving and 3D scanning.

### BRIEF DESCRIPTION OF DRAWINGS

FIG. 1 is a schematic diagram showing a structure of a first embodiment of an array-type light source light-splitting device of the present disclosure; and
FIG. 2 is a schematic diagram showing a structure of a second embodiment of the array-type light source light-splitting device of the present disclosure.

### DETAILED DESCRIPTION

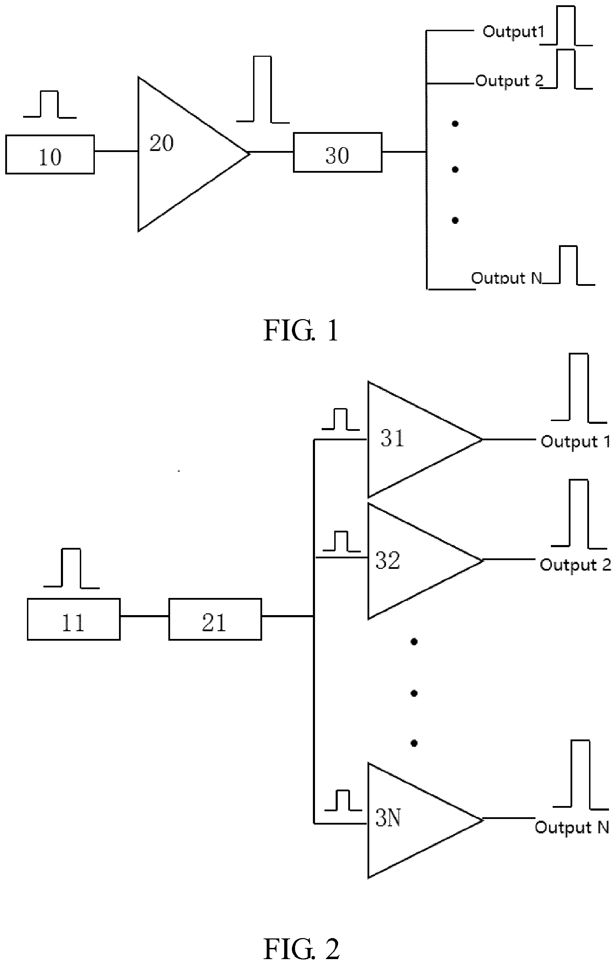

FIG. 1 is a schematic diagram showing a structure of a first embodiment of an array-type light source light-splitting device of the present disclosure. The array-type light source light-splitting device includes a seed source 10 inputting signal light, an optical fiber amplifier 20 connected with the seed source 10, and a light splitter 30 connected with the optical fiber amplifier 20. The light splitter 30 includes N paths of optical fibers. N is a natural number.

The N paths of optical fibers are arranged parallelly. The N paths of optical fibers includes a first path optical fiber, a second path optical fiber, a third path optical fiber..., and a Nth path optical fiber. Furthermore, the seed source is a laser with a wavelength of 1550 nm. The optical fiber amplifier includes rare-earth-doped elements internally. That is to say, the rare-earth-doped elements in the optical fiber amplifier 20 realizes an amplification of 1550 nm signal light. The light splitter 30 splits the signal light of the seed source 10 into multi-path (1, 2, 3,...N) and outputs them.

In the embodiment, the seed source is the laser with the wavelength of 1550 nm, and a repetition rate of the 1550 nm laser is able to reach megahertz. Moreover, the laser has a high-water absorption coefficient, and when the laser beam radiates to the human eye, a damage threshold to the human eye is high. Thus, the laser in the band is safety to the human eye.

In one embodiment, the present disclosure further provides a light-splitting method of the array-type light source light-splitting device, including following steps:
Step 1: emitting signal light to an optical fiber amplifier 20 by a seed source 10;
Step 2: obtaining the signal light of the seed source 10 by the optical fiber amplifier 20, and the optical fiber amplifier20 amplifies the signal light of the seed source 10 and increases a power of the signal light of the seed source 10;
Step 3: outputting the signal light of the seed source 10 to a light splitter 30 by the optical fiber amplifier 20; and
Step 4: splitting the signal light of the seed source 10 into N paths and outputting by the light splitter 30.

The seed source 10 of the present disclosure is served as a light source for generating continuous or pulsed signal light. An output end of the seed source 10 is fused to an input end of the optical fiber amplifier 20 through an optical fiber, and the signal light from the seed source 10 passes through the optical fiber amplifier 20 to obtain gain amplification. And the optical power is increased. An output end of the optical fiber amplifier 20 and an input end of the light splitter 30 are fused by an optical fiber. The light splitter 30 includes N paths, each of which is outputted in a form of an optical fiber. Thus, the signal light of the seed source 10 is amplified by the optical fiber amplifier 20 and then passed through the light splitter 30 to be a multi-path signal light output.

FIG. 2 is a schematic diagram showing a structure of a second embodiment of the array-type light source light-splitting device of the present disclosure. The array-type light source light-splitting device includes a seed source 11 inputting signal light, a light splitter 21 connected with the seed source 11, and N optical fiber splitters 3N connected with the light splitter 21. The N optical fiber splitters 3N are arranged parallelly. The N optical fiber splitters 3N includes a first optical fiber amplifier 31, a second optical fiber amplifier32, a third optical fiber amplifier 33..., and a Nth optical fiber amplifier 3N.

In the embodiment, the seed source 11 is the laser with the wavelength of 1550 nm, and a repetition rate of the 1550 nm laser is able to reach megahertz. Moreover, the laser has the high-water absorption coefficient, and when the laser beam radiates to human eyes, the damage threshold to the human eyes is high. Thus, the laser in the band is safety to the human eyes.

The light splitters 21 splits the signal light of the seed source 11 into N paths, and then realizes 1550 nm signal light amplification through a plurality of optical fiber splitters 3N including rare-earth-doped elements, thereby obtaining multi-path signal synchronous operation.

In one embodiment, the present disclosure further provides a light-splitting method of the array-type light source light-splitting device including following steps:
Step 1: emitting signal light with a wavelength of 1550 nm to a light splitter 21 by a seed source 11;
Step 2: obtaining the signal light of the seed source 11 by the light splitter 21, and the light splitter 21 splits the signal light of the seed source 11 in to N paths;
Step 3: entering the first optical fiber amplifier 31, the second optical fiber amplifier 32, the third optical fiber amplifier 33, ... the Nth optical fiber amplifier 3N sequentially from the N paths of the signal light split by the light splitter 21; and
Step 4: amplifying the signal light of the seed source and increasing a power of the signal light of the seed source by the first optical fiber amplifier 31, the second optical fiber amplifier 32, the third optical fiber amplifier 33, ... and the Nth fiber optical amplifier 3N, and output the signal light of the seed source respectively.

The seed source 11 of the present disclosure is served as a light source for generating continuous or pulsed signal light. An output end of the seed source 11 is fused to an input end of the light splitter 21 through an optical fiber. The light splitter includes N paths, each of which is outputted in a form of an optical fiber. Each branch takes the form of an optical fiber as an output, and the signal light of each path passes through the optical fiber amplifier 3N, and gain is amplified, and the optical power is increased.

The light splitter splits the signal light of the seed source of the present disclosure into multi-path signal light and outputs them, meanwhile the optical power is amplified by the optical fiber amplifier of each path to become the multi-path signal light and outputs them. The repetition rate of the 1550 nm laser is able to reach megahertz. Moreover, the laser has the high-water absorption coefficient, and when the laser beam radiates to the human eyes, the damage threshold to the human eye is high. Thus, the laser in the band is safety to the human eyes. The light source of the present disclosure adopts a synchronous working mode, and has broad application prospects in fields of automatic driving and 3D scanning.

The above content is a further detailed description of the present disclosure in conjunction with the specific preferred embodiments, and the specific implementation of the present disclosure is not limited to the description. It will be apparent that equivalent changes or modifications made in accordance with the scope of the present disclosure, which should be considered as being within the scope of the present disclosure.

## Claims

1. An array-type light source light-splitting device, comprising a seed source inputting signal light, an optical fiber amplifier connected with the seed source, and a light splitter connected with the optical fiber amplifier; wherein the light splitter comprises N paths of optical fibers; N is a natural number; the light splitter splits the signal light of the seed source into N paths and outputs them.

2. The array-type light source light-splitting device according to claim 1, wherein the N paths of optical fibers are arranged parallelly; the N paths of optical fibers comprises a first path optical fiber, a second path optical fiber, a third path optical fiber..., and a Nth path optical fiber.

3. The array-type light source light-splitting device according to claims 1 or 2, wherein the seed source is a laser with a wavelength of 1550 nm.

4. The array-type light source light-splitting device according to claims 1 or 2, wherein the optical fiber amplifier comprises rare-earth-doped elements internally.

5. A light-splitting method of the array-type light source light-splitting device according to any claims 1-4, comprising following steps:
emitting signal light to an optical fiber amplifier by a seed source;
obtaining the signal light of the seed source by the optical fiber amplifier, and the optical fiber amplifier amplifies the signal light of the seed source and increases a power of the signal light of the seed source;
outputting the signal light of the seed source to a light splitter by the optical fiber amplifier; and
splitting the signal light of the seed source into N paths and outputting by the light splitter.

6. An array-type light source light-splitting device, comprising a seed source inputting signal light, a light splitter connected with the seed source, and N optical fiber splitters connected with the light splitter, wherein N is a natural number; the N optical fiber splitters split the signal light of the seed source into N paths and output them.

7. The array-type light source light-splitting device according to claim 6, wherein the N optical fiber splitters are arranged parallelly; the N optical fiber splitters comprises a first optical fiber amplifier, a second optical fiber amplifier, a third optical fiber amplifier..., and a Nth optical fiber amplifier.

8. The array-type light source light-splitting device according to claims 6 or 7, wherein the seed source is a laser with a wavelength of 1550 nm.

9. The array-type light source light-splitting device according to claims 6 or 7, wherein the optical fiber amplifier comprises rare-earth-doped elements internally.

10. A light-splitting method of the array-type light source light-splitting device according to any claims 6-9, comprising following steps:
emitting signal light to a light splitter by a seed source;
obtaining the signal light of the seed source by the light splitter, and the light splitter splits the signal light of the seed source in to N paths;
entering the first optical fiber amplifier, the second optical fiber amplifier, the third optical fiber amplifier ..., and the Nth optical fiber amplifier sequentially from the N paths of the signal light split by the light splitter; and
amplifying the signal light of the seed source and increasing a power of the signal light of the seed source by the first optical fiber amplifier, the second optical fiber amplifier, the third optical fiber amplifier..., and the Nth fiber optical amplifier, and output the signal light of the seed source respectively.
